# EUROPEAN PATENT APPLICATION

(11) **EP 2 073 617 A2**
(43) Date of publication of application: **24.06.2009**
(21) Application number: 08254005.5
(22) Date of filing: 15.12.2008
(51) Int. Cl.: H05K 7/20

(54) **System and method for controlling the cooling of variable heat loads in heat generating devices**

(30) Priority: 19.12.2007 US 2970
(71) Applicant: Thermal Form & Function LLC, Kenton, Ohio 43326 (US)
(72) Inventor: Marsala, Joseph, Manchester, MA 01944 (US)
(74) Representative: White, Duncan Rohan

(57) **Abstract**

The present invention offers an improvement over prior art cooling systems by accounting for rapid changes in thermal load. The circulation rate of refrigerant in a cooling cycle is set so that the two phase mixture exiting the cold plate evaporator device (18) stays within a saturation dome of all mixtures between a saturated liquid and a saturated vapor. Furthermore, the two phase mixture exiting the cold plate evaporator device (18) is allowed to move within the saturation dome so that the exit quality of the two phase mixture leaving the cold plate evaporator device (18) changes with the heat load being removed. In this way, rapid changes in heat load are removed from the component (20) or components in contact with the cold plate evaporator device (18) without having to change the circulation rate of refrigerant in the cycle. Only the exit quality of the vapor leaving the cold plate/evaporator (18) changes.

## Description

### Technical Field

The present invention relates to cooling of electrical, electronic and optical components, and more particularly, to using a pumped liquid two phase cooling system to cool heat generating devices, including microprocessor semiconductors and power semiconductors, during rapid thermal load changes.

### Background of the Invention

Electrical, electronic and optical components (e.g. microprocessors, IGBT's, power semiconductors etc.) are most often cooled by air-cooled heat sinks with extended surfaces, directly attached to the surface to be cooled. A fan or blower moves air across the heat sink fins, removing the heat generated by the component. With increasing power densities, miniaturization of components, and shrinking of packaging, it is sometimes not possible to adequately cool electrical and electronic components with heat sinks and forced air flows. When this occurs, other methods must be employed to remove heat from the components.

One method for removing heat from components when direct air-cooling is not possible uses a single-phase fluid which is pumped to a cold plate. The cold plate typically has a serpentine tube attached to a flat metal plate. The component to be cooled is thermally attached to the flat plate and a pumped single-phase fluid flowing through the tube removes the heat generated by the component.

There are many types of cold plate designs, some of which involve machined grooves instead of tubing to carry the fluid. However all cold plate designs operate similarly by using the sensible heating of the fluid to remove heat. The heated fluid then flows to a remotely located air-cooled coil where ambient air cools the fluid before it returns to the pump and begins the cycle again. This method of using the sensible heating of a fluid to remove heat from electrical and electronic components is limited by the thermal capacity of the single phase flowing fluid. For a given fluid to remove more heat, either its temperature must increase or more fluid must be pumped. This creates high temperatures and/or large flow rates to cool high power microelectronic devices. High temperatures may damage the electrical or electronic devices, while large flow rates require pumps with large motors which consume parasitic electrical power and limit the application of the cooling system. Large flow rates may also cause erosion of the metal in the cold plate due to high fluid velocities.

Another method for removing heat from components when air-cooling is not feasible uses heat pipes to transfer heat from the source to a location where it can be more easily dissipated. Heat pipes are sealed devices which use a condensable fluid to move heat from one location to another. Fluid transfer is accomplished by capillary pumping of the liquid phase using a wick structure. One end of the heat pipe (the evaporator) is located where the heat is generated in the component, and the other end (the condenser) is located where the heat is to be dissipated. Often, the condenser end is in contact with extended surfaces such as fins to help remove heat to the ambient air. This method of removing heat is limited by the ability of the wick structure to transport fluid to the evaporator. At high thermal fluxes, a condition known as "dry out" occurs where the wick structure cannot transport enough fluid to the evaporator and the temperature of the device will increase, perhaps causing damage to the device. Heat pipes are also sensitive to orientation with respect to gravity. That is, an evaporator which is oriented in an upward direction has less capacity for removing heat than one which is oriented downward, where the fluid transport is aided by gravity in addition to the capillary action of the wick structure. Finally, heat pipes cannot transport heat over long distances to remote dissipaters due once again to capillary pumping limitations.

Yet another method which is employed when direct air-cooling is not practical uses the well-known vapor compression refrigeration cycle. In this case, the cold plate is the evaporator of the cycle. A compressor raises the temperature and pressure of the vapor, leaving the evaporator to a level such that an air-cooled condenser can be used to condense the vapor to its liquid state and be fed back to the cold plate for further evaporation and cooling. This method has the advantage of high isothermal heat transfer rates and the ability to move heat considerable distances. However, this method suffers from some major disadvantages which limit its practical application in cooling electrical and electronic devices. First, there is the power consumption of the compressor. In high thermal load applications the electric power required by the compressor can be significant and exceed the available power for the application. Another problem concerns operation of the evaporator (cold plate) below ambient temperature. In this case, poorly insulated surfaces may be below the dew point of the ambient air, causing condensation of liquid water and creating the opportunity for short circuits and hazards to people. Vapor compression refrigeration cycles are designed so as not to return any liquid refrigerant to the compressor which may cause physical damage to the compressor and shorten its life by diluting its lubricating oil. In cooling electrical, electronic and optical devices, the thermal load can be highly variable, causing unevaporated refrigerant to exit the cold plate and enter the compressor. This can cause damage and shorten the life of the compressor. This is yet another disadvantage of vapor compression cooling of components.

Existing methods of cooling heat generating devices using a pumped liquid two phase cooling system are disclosed in commonly assigned U.S. Patent Nos. 6,519,955 and 6,679,081, totally incorporated herein by reference. However, in cooling electrical, electronic and optical devices, often the heat load to be removed changes rapidly almost to the point of being instantaneous. An example is cooling microprocessors where the change from an idle state to burst or full power occurs in much less than a fraction of a second. The same is true in cooling diode lasers where nearly instantaneous changes in heat output can occur. In prior art cooling devices a number of techniques are used to address this rapid change in thermal load. The simplest method is also the most inefficient, that is to operate the fan in the air cooled heat sink or the pump in a single phase cold plate loop to the maximum required flowrate at all times. This is wasteful of energy and can cause premature failure of the fan or pump since they must run at full capacity all the time. Improvements to this brute force approach call for adding variable speed controls to fans and pumps. This adds cost and complexity to the cooling system and sensors are required to tell when more cooling is required.

The situation with vapor compression cycle cooling is even more difficult because the compressor can be damaged by unevaporated liquid due to sudden changes in thermal load. In this case, a suction accumulator should be used to protect the compressor and a sensor at the exit of the evaporator needs to sense when all of the liquid refrigerant has been evaporated or not, at the exit of the evaporator. Then changes to the speed of the compressor must be made to match the load to the compressor output. These variable speed compressors, suction accumulators and associated controls are expensive and complex. Heat pipes are passive devices and can only change the rate at which they remove heat as a function of their inherent capillary liquid pumping rate.

It is seen then that there exists a continuing need for a system and method for cooling variable heat loads in electrical, electronic and optical components.

### Summary of the Invention

This need is met by the system and method of the present invention of providing control of the operation of two phase cooling loops to account for rapid changes in thermal load.

In accordance with one aspect of the present invention, cooling of variable heat loads in electrical, electronic and optical components is achieved by pumped two phase loops, without the high pumping rates required by single phase pumped loops sized to handle the dame loads. The invention requires that the circulation rate of refrigerant in the cooling cycle be set, so that there is always a two phase mixture leaving the cold plate/evaporator(s) in the thermodynamic cooling cycle.

Accordingly, it is an object of the present invention to provide cooling to electrical, electronic and optical components. It is a further object of the present invention to provide such cooling to components operating under varying heat loads. It is yet another object of the present invention to provide pumped two phase cooling loops without the high pumping rates required by single phase pumped loops handling such loads.

Other objects and advantages of the invention will be apparent from the following description, the accompanying drawings and the appended claims.

### Brief Description of the Drawings

Fig. 1A is a schematic block diagram illustrating a parallel configuration of the pumped liquid cooling system in accordance with the present invention;
Fig. 1B is a schematic block diagram illustrating a series configuration of the pumped liquid cooling system in accordance with the present invention;
Fig. 2 illustrates a plurality of cold plate evaporator devices, each in thermal contact with a component to be cooled; and
Fig. 3 is a generalized pressure enthalpy diagram illustrating a thermodynamic cooling cycle.

### Detailed Description of the Preferred Embodiments

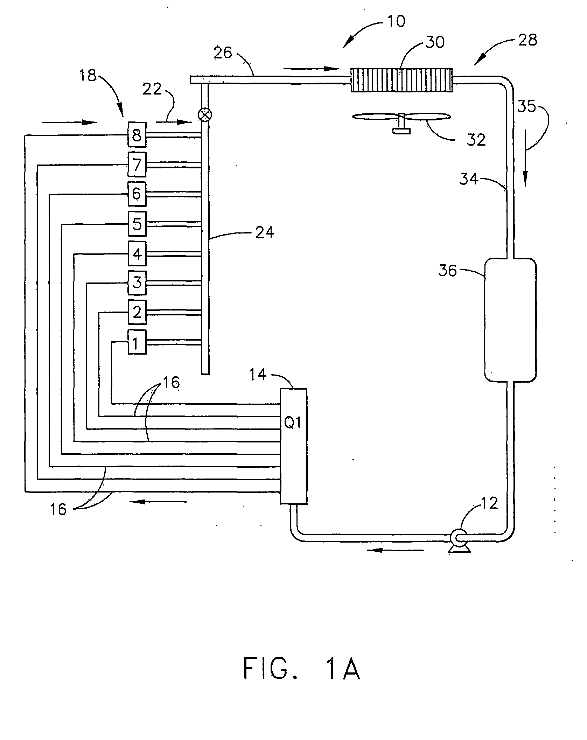

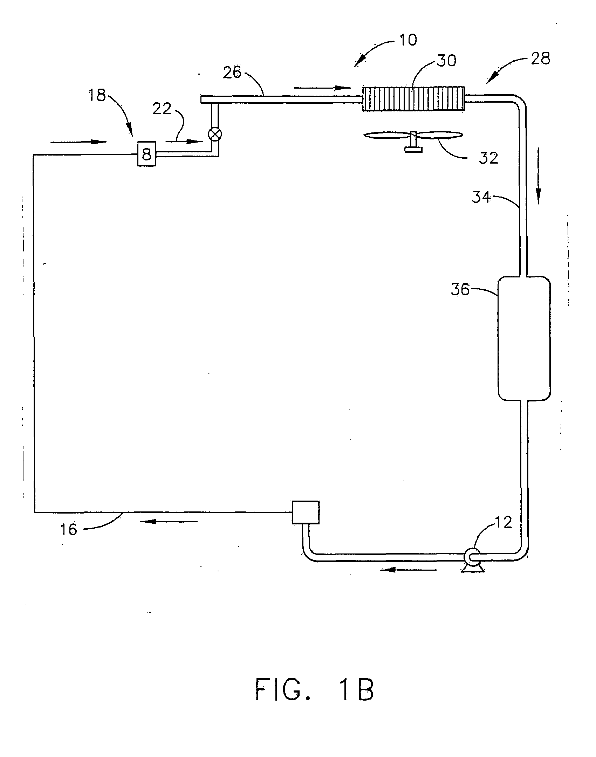

Referring now to Figs. 1A and 1B, there is illustrated a cooling system 10 which circulates a refrigerant as the working fluid. The refrigerant may be any suitable vaporizable refrigerant, such as R-134a. The cooling cycle can begin at liquid pump 12, shown as a Hermetic Liquid Pump. Pump 12 pumps the liquid phase refrigerant to a liquid manifold 14 , where it is distributed to one or a plurality of branches or lines 16. From the manifold 14, each branch or line 16 feeds liquid refrigerant to a cold plate 18. The condensing temperature of the refrigerant is preferably controlled so as to be above the ambient dew point where the cold plate evaporator device is located.

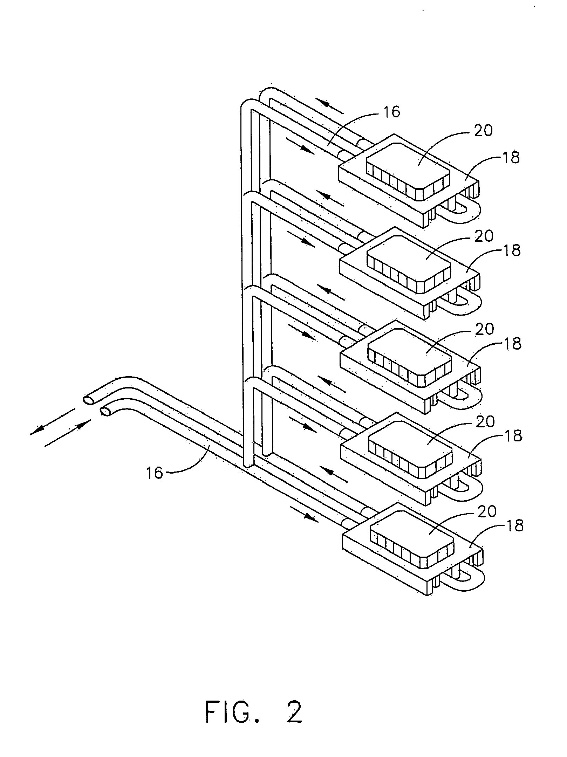

As illustrated in Fig. 2, each cold plate 18 is in thermal contact with an electrical or electronic component or components 20 to be cooled, causing the liquid refrigerant to evaporate at system pressure. None, some, or all of the liquid refrigerant may evaporate at cold plate 18, depending on how much heat is being generated by component 20. In most cases, some of the refrigerant will have evaporated and a two-phase mixture of liquid and vapor refrigerant will leave each cold plate 18, as shown by arrow 22 in Figs. 1A and 1B.

At this point in the operation of the system, each cold plate 18 discharges its mixture of two-phase refrigerant to conduit 24, as illustrated in Figs. 1A and 1B. For most applications, the conduit 24 is a tube. The conduit 24 is attached to condenser 28, comprised of a condensing coil 30 and a fan 32. Condenser coil 30, attached to conduit 24, condenses the vapor phase back to a liquid and removes the heat generated by the electronic components 20, shown in Fig. 2. Any unevaporated liquid in conduit 24 merely passes through condenser 28. In Figs. 1A and 1B, an ambient air-cooled condenser 28 is shown, using fan 32, although it will occur to those skilled in the art that any suitable form of heat rejection may be used without departing from the scope of the invention, such as an air cooled condenser, a water or liquid cooled condenser, or an evaporative condenser.

The condenser 28 operates at a pressure which corresponds to a temperature somewhat higher than the dew point temperature of the ambient air. In this way, it is impossible for water condensation to form, since no system temperature will be below the ambient dew point temperature. The condenser operating point sets the pressure of the entire system by means of the entering coolant temperature and its ability to remove heat from the condenser, thus fixing the condensing temperature and pressure. Also, since vaporized refrigerant is being condensed to a liquid phase, the condenser 28 sets up a flow of vaporized refrigerant from the conduit 24 into the condenser 28, without the need for any compressor to move the vapor from the cold plate-evaporator 18 to the condenser 28. The liquid refrigerant exits the condenser 28, travels through conduit 34 as indicated by arrow 35, and moves to an additional volume 36, which holds a quantity of liquid refrigerant. Pump 12 pumps the liquid refrigerant from the additional volume 36 into the cold plate where the refrigerant evaporates, becoming a two-phase mixture, all without the need of any vapor/liquid separation. The two-phase mixture leaves the cold plate and goes into the condenser, which condenses the vapor into liquid, so that only liquid leaves the condenser.

The outlet of the additional volume 36 is connected to the inlet of the liquid refrigerant pump 12. At the pump 12, the pressure of the refrigerant is raised sufficiently to overcome the frictional losses in the system and the cooling cycle begins again. The pump 12 is selected so that its pressure rise is equal to or exceeds the frictional loss in the system at the design flow rate.

The present invention will allow for the cooling of variable heat loads in electrical, electronic and optical components by pumped two phase loops without the high pumping rates required by single phase pumped loops sized to handle the same loads. Also, when compared to heat pipes, dry out is avoided by using this method which will protect the components from damage due to excess heat.

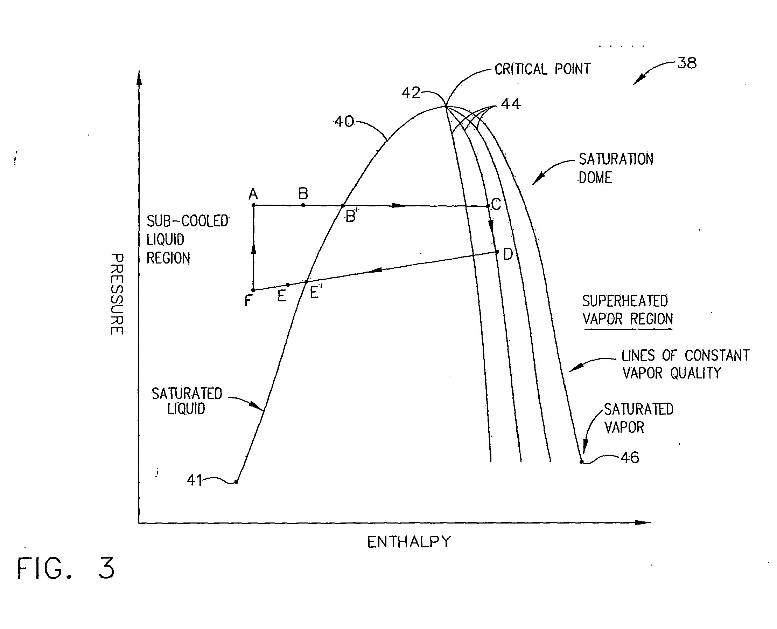

For the purpose of explaining the benefits of the present invention, a generalized pressure enthalpy diagram 38 is provided as Figure 3. In this thermodynamic cooling cycle, the operation may be understood by following the state points on the pressure enthalpy diagram. Starting at the pump inlet (point F), slightly subcooled liquid refrigerant has its pressure increased by the pump from point F to point A on diagram 38, to the left of saturation dome 40. The refrigerant then leaves the discharge of the pump and proceeds to the entrance of the evaporator, or cold plate 18, at point B on the diagram. This is represented by point A to point B on pressure enthalpy diagram 38. There is a slight downward slope to the line AB, which represents the pressure loss in the line moving the liquid refrigerant to the inlet of the cold plate evaporator 18.

Continuing with Fig. 3, the refrigerant is still in a subcooled liquid state at point B. In the evaporator/cold plate 18, the subcooled liquid refrigerant is heated sensibly by the heat rejected from the electrical, electronic or optical device until it reaches its saturation temperature at point B' (B prime). At this point in the cold plate/evaporator 18, the refrigerant begins to boil or evaporate and becomes a two phase mixture of liquid and vapor. This boiling or evaporation of refrigerant continues until all of the heat from the device to be cooled, component 20, has been absorbed by the refrigerant at point C. Point C is still a two phase mixture of refrigerant liquid and vapor. The slight downward slope of the line AB still represents the pressure drop of the cold plate/evaporator 18 and associated tubing connections. The flatter line AB is, the more isothermal the cold plate/evaporator 18 operates.

At point C on the pressure enthalpy diagram 38, the refrigerant mixture leaves the cold plate/evaporator 18 and proceeds to the condenser 28 entrance, represented by point D on diagram 38. The connection between the cold plate/evaporator 18 exit and the condenser 28 entrance is represented by line CD, the line from point C to point D. For some low pressure drop cases, line CD as represented on the pressure enthalpy diagram may be so short as to make points C and D essentially the same point. For illustration purposes, but not to be considered as limiting the scope of the invention, diagram 38 shows line CD with a pressure drop.

The two phase refrigerant mixture enters the condenser 28 at point D and begins to condense, causing the state of the refrigerant mixture to change to a more liquid phase and a less vapor phase. This is also a reduction in the vapor quality within the saturation dome 40. At point E' (E prime) the vapor has been completely condensed and only a saturated liquid phase is present in the condenser. As more heat is removed from the liquid phase in the condenser, the liquid becomes sub cooled from point E' to point E to the left of the saturation dome 40.

In Fig. 3, point E represents the exit of the condenser 28. Point E to point F represents the line from the exit of the condenser to the inlet of the pump 12. The cycle is now complete and can begin again.

The line from point D to point F is shown with a slight downward slope which represents the pressure drop through the condenser 28 and associated tubing connections.

In Fig. 3, the line AB illustrates the pump discharge to the evaporator/cold plate inlet, and enters subcooled. Line BC illustrates the exit from the evaporator/cold plate, and this is always a two phase mixture at point C. Line CD illustrates the line from the evaporator/cold plate exit to the condenser inlet. Line DE is to the condenser, and exits subcooled. Line EF illustrates the line from the condenser exit to the pump inlet. Finally, line FA illustrates pump pressure rise. Downward sloping lines represent pressure drops, and upward sloping lines represent a pressure rise.

In Fig. 3, the saturation dome 40 in the pressure enthalpy diagram starts with a saturated liquid, at the lowest pressure and enthalpy point, point 41. As the pressure and enthalpy rise, the critical point is reached at point 42, at the highest pressure and enthalpy, as liquid and vapor mix. Lines 44 represent lines of constant vapor quality. At the lowest pressure and highest enthalpy, at point 46, the mixture has become saturated vapor. Outside the saturation dome to the left is a sub-cooled liquid region, and outside the saturation dome to the right is a superheated vapor region.

In alternative embodiments of the present invention, the refrigerant working fluid can be moved from point C to point E using a vapor liquid separator with a condenser. Also, the cold plate/evaporator as represented by the line from point B to point C may be a single cold plate/evaporator as described or may by multiple cold plate/evaporators in series or parallel or a combination of series and parallel flow arrangements, such as illustrated in Fig. 2. Likewise, the condenser may be a single condenser or multiple condensers rejecting heat to air or another fluid as necessary. Finally, single or multiple pumps may be used without departing from the intent of the invention. Hence, those skilled in the art will recognize that the scope and purpose of the invention can be achieved with multiple configurations, without changing its essence.

The present invention requires that the circulation rate of refrigerant in the cooling cycle, represented by following the path on the pressure enthalpy diagram 38 represented by state points ABCDEF, be set so that point C never reaches the saturated vapor line of the saturation dome. That is, point C is always a two phase mixture leaving the cold plate/evaporator(s). The saturation dome starts at saturated liquid point 41 and extends to saturated vapor point 46 to include all liquid vapor mixtures in between the saturated liquid and the saturated vapor. Furthermore, point C is allowed to move within the saturation dome so that the exit quality of the two phase mixture leaving the cold plate/evaporator(s) changes with the heat load being removed by the cold plate/evaporator(s). In this way, rapid changes in heat load are removed from the component(s) in contact with the cold plate/evaporator(s) without having to change the circulation rate of refrigerant in the cycle. Only the exit quality of the vapor leaving the cold plate/evaporator changes.

Consequently, the circulation rate of refrigerant in the cooling cycle is set higher than the maximum required to evaporate all of the refrigerant at the highest design heat load for the system. At no condition will the electrical, electronic or optical component heat load evaporate all of the refrigerant and leave no liquid refrigerant in the cold plate/evaporators. Implementation of the present invention avoids the need to use vapor compression cooling when systems require isothermal cooling of components under varying loads.

Unlike pumped liquid single-phase systems, the present invention can operate isothermally, since it can use change of phase to remove heat rather than the sensible heat capacity of a liquid coolant. This allows for cooler temperatures at the evaporator and cooler components than a single-phase liquid system. Low liquid flow rates are achieved through the evaporation of the working fluid to remove heat, keeping the fluid velocities low and the pumping power very low for the heat removed. Parasitic electric power is reduced over both the pumped single-phase liquid system and the vapor compression refrigeration system.

The cooling system control of the present invention comprises at least one component generating heat and required to be cooled, and at least one cold plate evaporator device in thermal contact with the at least one component. A vaporizable refrigerant is circulated by the liquid refrigerant pump to the at least one cold plate evaporator device, whereby the refrigerant is at least partially evaporated by the heat generated by the at least component(s), creating a vapor. A condenser condenses the partially evaporated refrigerant vapor, creating a single liquid phase. The vaporizable refrigerant from the pump is received by a first liquid conduit connected to the cold plate evaporator device(s). A second conduit from the cold plate evaporator devices), is connected to the condenser. A liquid return line is provided from the condenser to an inlet of the refrigerant pump.

An advantage over the heat pipe system is obtained with the present invention because the liquid flow rate does not depend on capillary action, as in a heat pipe, and can be set independently by setting the flow rate of the liquid pump. Dry out can thus be avoided. The cold plate/evaporator system of the present invention is insensitive to orientation with respect to gravity. Unlike heat pipe systems, the thermal capacity of the evaporator 18 of the present invention does not diminish in certain orientations.

The present invention controls the cooling of variable heat loads in heat generating devices. The circulation rate of refrigerant in the cooling cycle is set higher than the maximum required to evaporate all of the refrigerant at the highest design heat load for the system. There is always a point of two phase mixture leaving the cold plate/evaporator, and that point is allowed to move within the saturation dome. This allows the exit quality of the two phase mixture leaving the cold plate/evaporator to change with the heat load being removed from the component or components that are in contact with the cold plate/evaporator. This is accomplished without having to change the circulation rate of refrigerant in the cycle. Hence, the present invention easily handles variation in thermal load of the components to be cooled.

Having described the invention in detail and by reference to the preferred embodiment thereof, it will be apparent that other modifications and variations are possible without departing from the scope of the invention defined in the appended claims.

## Claims

1. A pumped liquid multiphase cooling cycle method for controlling the cooling of variable heat loads in heat generating devices, comprising the steps of:
providing at least one component generating heat and required to be cooled;
providing at least one cold plate evaporator device in thermal contact with the at least one component;
providing a liquid refrigerant pump having at least an inlet;
providing a vaporizable refrigerant circulated by the liquid refrigerant pump to the at least one cold plate evaporator device, whereby the refrigerant is at least partially evaporated by the heat generated by the at least one component, creating a vapor;
providing a condenser for condensing the partially evaporated refrigerant vapor, creating a single liquid phase;
providing a first liquid conduit for receiving the vaporizable refrigerant from the liquid refrigerant pump, said first liquid conduit connected to the at least one cold plate evaporator device;
providing a second conduit from the at least one cold plate evaporator device, said second conduit connected to the condenser;
providing a liquid return line from the condenser to the inlet of the refrigerant pump; and
allowing a two phase liquid vapor mixture exiting the cold plate evaporator device to adjust within a saturation dome defined by the pumped liquid multiphase cooling cycle whereby exit quality of the two phase liquid vapor mixture leaving the cold plate evaporator device changes with the variable heat loads being removed by the cold plate evaporator device.

2. A method as claimed in claim 1 further comprising the step of containing an additional volume in the pumped liquid multiphase cooling cycle to provide for storage of liquid refrigerant when liquid refrigerant is displaced in the cold plate evaporator device and the condenser by vapor during the cooling operation.

3. A method as claimed in claim 1 or 2 wherein the at least one cold plate evaporator device comprises at least two cold plate evaporator devices.

4. A method as claimed in claim 3 wherein the at least two cold plate evaporator devices are in series flow.

5. A method as claimed in claim 3 wherein the at least two cold plate evaporator devices are in parallel flow.

6. A pumped liquid multiphase cooling cycle system for controlling the cooling of variable heat loads in heat generating devices, comprising:
at least one component generating heat and required to be cooled;
at least one cold plate evaporator device in thermal contact with the at least one component;
a liquid refrigerant pump having at least an inlet;
a vaporizable refrigerant circulated by the liquid refrigerant pump to the at least one cold plate evaporator device, whereby the refrigerant is at least partially evaporated by the heat generated by the at least one component, creating a vapor;
a condenser for condensing the partially evaporated refrigerant vapor, creating a single liquid phase;
a first liquid conduit for receiving the vaporizable refrigerant from the liquid refrigerant pump, said first liquid conduit connected to the at least one cold plate evaporator device;
a second conduit from the at least one cold plate evaporator device, said second conduit connected to the condenser;
a liquid return line from the condenser to the inlet of the refrigerant pump; and
a saturation dome defined by the pumped liquid multiphase cooling cycle, the saturation dome containing a saturated liquid point, a saturated vapor point, and all mixtures between, whereby the two phase liquid vapor mixture exiting the cold plate evaporator device is allowed to move within the saturation dome so exit quality of the two phase liquid vapor mixture leaving the cold plate evaporator device changes with the variable heat loads being removed by the cold plate evaporator device.

7. A system as claimed in claim 6 further comprising an additional volume contained in the pumped liquid multiphase cooling cycle to provide for storage of liquid refrigerant when liquid refrigerant is displaced in the cold plate evaporator device and the condenser by vapor during the cooling operation.

8. A system as claimed in claim 6 or 7 wherein the at least one cold plate evaporator device comprises at least two cold plate evaporator devices.

9. A system as claimed in claim 8 wherein the at least two cold plate evaporator devices are in series flow.

10. A system as claimed in claim 8 wherein the at least two cold plate evaporator devices are in parallel flow.
